Europäisches Patentamt

European Patent Office

Office européen des brevets

(11) Publication number: **0 414 412 A2**

# EUROPEAN PATENT APPLICATION

(21) Application number: 90308691.6

(22) Date of filing: 07.08.90

(51) Int. Cl.5: **H01L 23/522**, H01L 23/485

The title of the invention has been amended (Guidelines for Examination in the EPO, A-III, 7.3).

(30) Priority: 22.08.89 JP 215545/89

(43) Date of publication of application:
27.02.91 Bulletin 91/09

(84) Designated Contracting States:
DE FR GB IT

(71) Applicant: HITACHI, LTD.

6, Kanda Surugadai 4-chome
Chiyoda-ku, Tokyo 100(JP)

(72) Inventor: Oogaya, Kaoru
Wakakusaryo, 657-5 Nogami
Ohme-shi, Tokyo(JP)

(74) Representative: Calderbank, Thomas Roger et al
MEWBURN ELLIS 2 Cursitor Street
London EC4A 1BQ(GB)

(54) Semiconductor integrated circuit device having wiring layers.

(57) In a semiconductor integrated circuit device wherein a dog-bone portion is formed around a contact hole which connects wiring lines in different layers and which is provided in, at least, either of wiring lines formed in an identical wiring layer and adjoining each other, each of the dog-bone portions (17a, 19a) is formed substantially in a shape in which its corners (20) are chamfered. In addition, a wiring line portion adjacent to the dog-bone portion (17a or 19a) in the wiring lines adjoining each other is indented in the direction of coming away from this dog-bone portion, whereby only the width of the indented wiring portion (17b or 19b) is made smaller than that of any other portion (17c or 19c) of the pertinent wiring line. Besides, the corners (22) of the indented wiring portion (17b or 19b) are chamfered. Further, in manufacturing the semiconductor integrated circuit device, at the step <413> of automatically designing a wiring layout, element cells for contact holes ($TH_{12}$ or $TH_{12}'$) each of which contains information for indenting only the wiring line portion adjacent to the dog-bone portion in the direction of coming away from this dog-bone portion are placed at the positions of the contact holes, thereby to realize the wiring structure described above.

FIG. 3A

# SEMICONDUCTOR INTEGRATED CIRCUIT DEVICE AND PROCESS FOR MANUFACTURING THE SAME

The present invention relates to the technology of semiconductor integrated circuit devices, and more particularly to wiring techniques for the semiconductor integrated circuit devices.

Wiring techniques for semiconductor integrated circuit devices are stated in, for example, Technical Digest of IEDM ( I nternational E lectron D evices M eeting) 1983 , pp. 542-545.

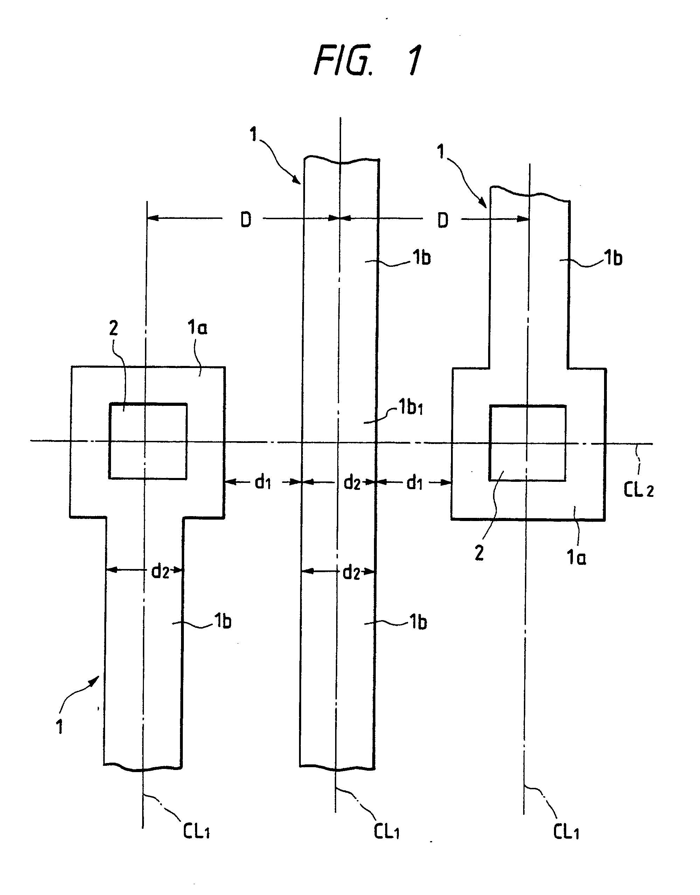

A wiring structure in the prior art is shown in Fig. 1. Referring to the figure, a dot-and-dash line extending vertically is a center line $CL_1$ which indicates the channel direction of a wiring line 1. The distance D between the center lines $CL_1$, $CL_1$ extending in parallel with each other corresponds to a channel pitch. Besides, a dot-and-dash line extending in a direction orthogonal to the center line $CL_1$ is a center line $CL_2$ which indicates the channel direction of an upper-layer wiring line (not shown) overlying the wiring lines 1. Through holes 2 for connecting the wiring lines 1 and the upper-layer wiring line are located at the points of intersection between the center lines $CL_1$ and the center line $CL_2$. In the wiring line 1, the through hole 2 is surrounded with a dog-bone portion 1a. In order to prevent the misregistration of the through hole 2 attributed to a mask misalignment, the dog-bone portion 1a is broader than the other portion 1b of the wiring line 1 and is in a rectangular shape.

In designing such a wiring structure, the minimum spacing between the wiring lines 1, 1 adjacent to each other and the minimum line width of the wiring line 1 are first determined. The minimum spacing is determined by the spacing $d_1$ between the dog-bone portion 1a and the other wiring line portion 1b adjacent thereto because the dog-bone portion 1a is broader than the wiring line portion 1b. On the other hand, the minimum line width is determined by the width $d_2$ of a wiring line portion $1b_1$ intervening between the dog-bone portions 1a, 1a.

In setting the line widths of the wiring lines, it has heretofore been common practice that, not only the width $d_2$ of the wiring line portion $1b_1$ intervening between the dog-bone portions 1a, 1a, but also the width of the wiring line portion 1b of the wiring line 1 not intervening between the dog-bone portions 1a, 1a is set at the minimum line width in order to ease the layout of the wiring lines and to render the layout more efficient.

As a semiconductor integrated circuit device with such a wiring structure, there has been known one which adopts a gate array scheme.

In the semiconductor integrated circuit device adopting the gate array scheme, basic cells arrayed regularly in the shape of a matrix and elements included in each of the basic cells are connected by a plurality of layers of wiring. The semiconductor integrated circuit device of this type has the feature that, since various logic circuits can be constructed merely by altering connection patterns, many kinds of products can be developed in a short term.

The connections in the semiconductor integrated circuit device adopting the gate array scheme are made by an automatic placement and routing system using a computer (DA: D esign A utomation).

The semiconductor integrated circuit device of the specified type adopting the gate array scheme is stated in, for example, "ISSCC DIGEST OF TECHNICAL PAPERS", pp. 72-73; Feb., 1988.

Regarding the prior-art technique wherein even the portion of each wiring line not intervening between the dog-bone portions is set at the minimum line width from the viewpoint of the easier layout of the wiring lines, the inventor has found out the problem that the width of such a wiring line portion is unnecessarily small, so the reliability of the wiring degrades drastically.

More specifically, the reliability of wiring conforms to the formula of [the rate of occurrence of disconnections $\alpha$ the rate of appearance of fine wiring lines x the rate of appearance of underlying stepped parts]. In the prior-art wiring structure, the rate at which the fine wiring lines appear in the whole semiconductor integrated circuit device and the probability at which the fine wiring lines lie over the underlying stepped parts rise more with the narrowing of the channel pitches and the consequent reduction of the minimum line width. Therefore, such a problem as EM (electromigration) defects, SM (stress migration) defects or increase in a wiring resistance is liable to take place.

Besides, especially in the semiconductor integrated circuit device adopting the gate array scheme, the wiring line pitches and the wiring line widths tend to narrow due to increase in the number of gates resulting from a heightened density of integration. Consequently, in the case where the connection patterns are formed by the DA treatment employing the prior-art technique, wiring resistances and wiring delays as required are prone to degrade the versatility of the connections and to pose the problem that the efficiency of packaging logic circuits lowers.

The present invention has been made with note taken of the above drawbacks, and has for its object to provide a technique which can enhance the reliability of wiring lines formed in a semiconductor integrated circuit device.

Another object of the present invention is to provide a technique which can enhance the reliability of wiring lines formed in a semiconductor integrated circuit device, without spoiling the easiness of a wiring layout.

Still another object of the present invention is to provide a technique which can raise the efficiency of packaging circuits, without spoiling the easiness of a wiring layout.

The aforementioned and other objects and novel features of the present invention will become apparent from the description of this specification when read with reference to the accompanying drawings.

Typical aspects of performance of the present invention are briefly summarized as follows:

As an expedient (1), in a semiconductor integrated circuit device having a plurality of stacked wiring layers, a wiring line which has a dog-bone portion around a contact hole for connecting the different wiring layers is constructed in a wiring line structure in which the corners of the dog-bone portion are chamfered.

Besides, in wiring lines which are formed in the same wiring layer and which adjoin each other, that portion of each of the wiring lines which is adjacent to the dog-bone portion is indented in the direction of coming away from the dog-bone portion, whereby only the wiring line portion is made narrower than the other portion of each of the wiring lines.

As an expedient (2), in manufacturing the semiconductor integrated circuit device of the above expedient (1) by the use of an automatic placement and routing system, the step of automatically designing a routing layout comprises the step of placing element cells for the contact holes at the positions of these contact holes, the element cells containing information for indenting only the wiring line portions adjacent to the dog-bone portions in the directions of coming away from them.

According to the expedient (1) described above, the rate at which fine wiring lines appear and the probability at which the fine wiring lines lie over underlying stepped parts can be much lowered as compared with those of the prior-art wiring line structure wherein the widths of all the wiring line portions except the dog-bone portions are set at the minimum line width. It is therefore possible to enhance, for example, the EM immunity and SM immunity of the wiring lines. Further, the resistances of the wiring lines can be lowered, and the reliability thereof can be enhanced.

Moreover, an inferior resolution which arises at exposure and development steps on account of the shortened spacing between the corner of any of the dog-bone portions and a wiring line portion opposing thereto obliquely or the corner of another of the dog-bone portions can be prevented, so that the reliability of the wiring lines can be enhanced. Also, the spacings between the dog-bone portions can be reduced, so that the wiring pitches can be shortened to raise the efficiency of packaging circuits.

According to the expedient (2) described above, in manufacturing the semiconductor integrated circuit device defined in the expedient (1), a wiring pattern can be designed at the step of automatically designing the routing layout so that, by way of example, only the wiring line portions intervening between the dog-bone portions may become the minimum line width. It is therefore permitted to enhance the reliability of the wiring lines and to raise the packaging efficiency of the circuits, without spoiling the easiness of the wiring layout.

The construction of the present invention will be described below in conjunction with embodiments in each of which the present invention is applied to a semiconductor integrated circuit device adopting a gate array scheme.

Throughout the drawings for describing the embodiments, the same symbols are assigned to portions of identical functions, which shall not be repeatedly explained.

**In the drawings:**

Fig. 1 is a partial plan view showing a wiring structure in the prior art;

Fig. 2 is a plan view of a semiconductor integrated circuit device which is the first embodiment of the present invention;

Figs. 3A and 3C are enlarged plan views of the essential portions of wiring lines formed in the semiconductor integrated circuit device, and Fig. 3B is a plan view showing a first wiring layer in Fig. 3A;

Figs. 4A and 4B are process flow charts showing a method of manufacturing the semiconductor integrated circuit device;

Figs. 5A thru 5C are partial plan views of layout plans showing the step of automatic routing layout in the method of manufacturing the semiconductor integrated circuit device;

Figs. 6A thru 6D are partial plan views of layout plans showing steps in the case where routing data generated by the automatic routing layout is converted into actual wiring pattern data;

Fig. 7 is a process flow chart showing a method of manufacturing a semiconductor integrated circuit device which is the second embodiment of the present invention;

Figs. 8A thru 8G are partial plan views of layout plans showing steps in the case where routing data generated by automatic routing layout is converted into actual wiring pattern data in a method of manufacturing the semiconductor integrated circuit device of the second embodiment; and

Fig. 9 is a plan view showing the pattern data of through hole cells for use in automatic routing layout in a method of manufacturing a semiconductor integrated circuit device which is the third embodiment of the present invention.

Embodiment 1:

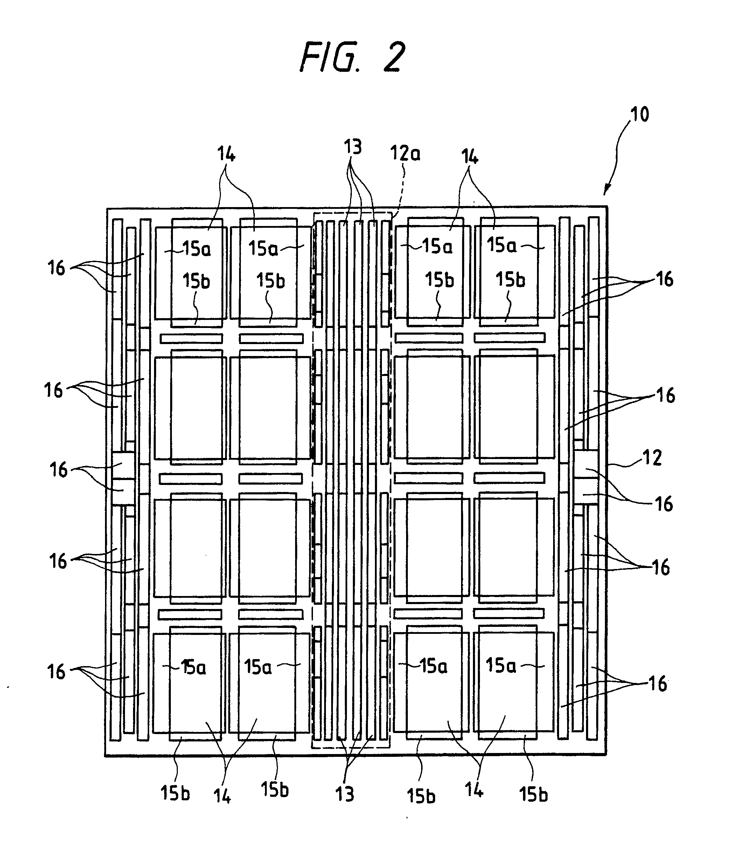

Fig. 2 is a plan view of a semiconductor integrated circuit device which is one embodiment of the present invention. The semiconductor integrated circuit device 10 is a hybrid gate array having a multilayer wiring structure.

A plurality of logic circuit blocks 13 are arranged in a logic circuit forming region 12a located centrally of a semiconductor chip (semiconductor substrate) 12 which is made of, for example, single-crystal silicon. From the viewpoints of heightening signal transfer speeds, lowering power consumption, etc., the logic circuit blocks 13 are constructed of Bi-CMOS (Bipolar-Complementary MOS) circuits.

Memory circuit blocks 14 in, for example, 2 columns and 4 rows are arranged on each of both the sides of the logic circuit forming region 12a. A static RAM, for example, is formed in each of the memory circuit blocks 14. In addition, peripheral circuit blocks such as an X decoder circuit 15a and a Y decoder circuit 15b are arranged around each memory circuit block 14.

Besides, in the semiconductor chip 12, a plurality of input/output circuit blocks 16 are arranged on each of the right and left sides of this chip as viewed in the figure. Likewise to the logic circuit blocks, the input/output circuit blocks 16 are constructed of Bi-CMOS circuits by way of example.

Basic cells, not shown, are formed in the shape of a matrix within the logic circuit forming region 12a. Logic elements, such as inverter circuits, NAND circuits, NOR circuits and flip-flop circuits, are constructed by connecting the inner parts of each basic cell and connecting the basic cells, and the logic circuits are constructed by connecting the logic elements.

The logic elements are registered as macrocells in an automatic placement and routing system to be described later, together with the information items of each macrocell such as connection patterns within the basic cells, delay parameters and a symbol table.

In this manner, the logic circuit blocks 13 are constructed of the basic cells which are configured of Bi-CMOS circuits. Such basic cells configured of Bi-CMOS circuits are stated in, for example, "ISSCC DIGEST OF TECHNICAL PAPERS", pp.

116-117; Feb., 1989.

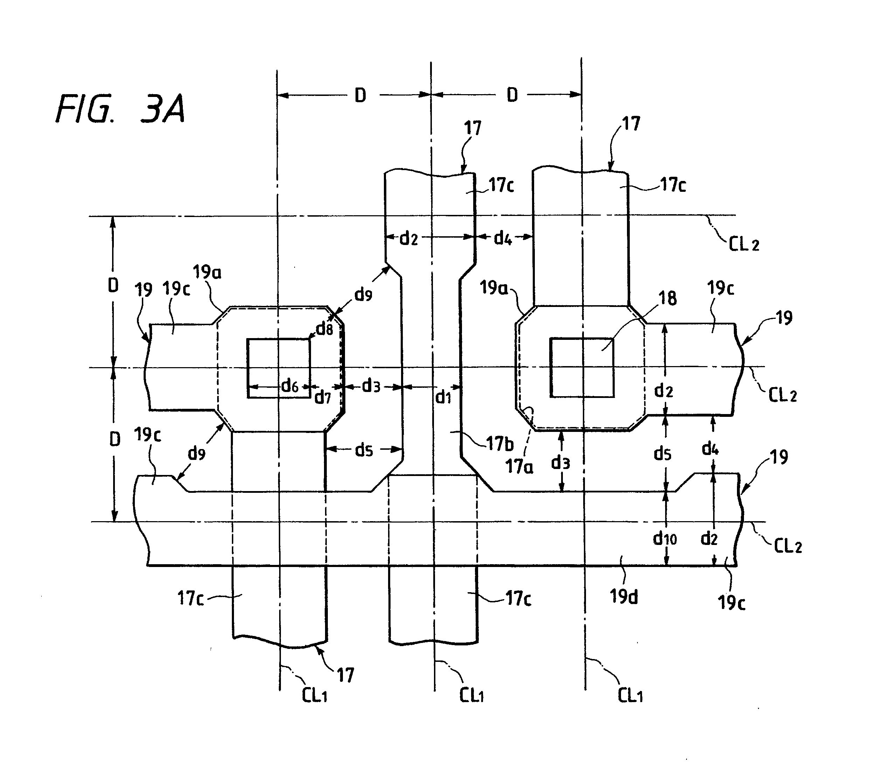

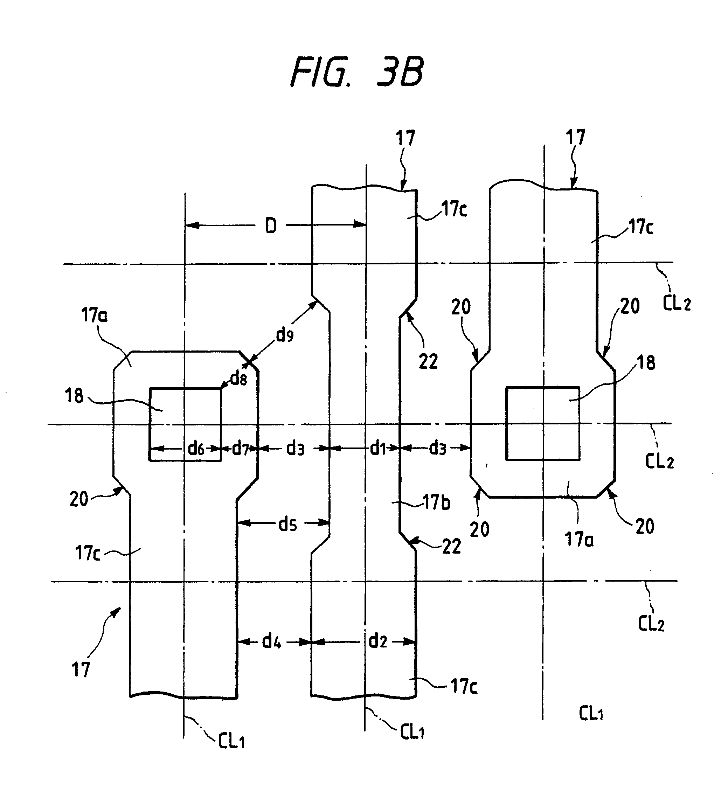

In the semiconductor integrated circuit device 10 of this embodiment, wiring lines which constitute the circuit blocks arranged in the semiconductor chip 12 are laid in a structure shown in Figs. 3A and 3B by way of example.

Dot-and-dash lines extending in the vertical direction (for example, X direction) in each of Figs. 3A and 3B are center lines $CL_1$ which indicate the channel directions of wiring lines 17 formed in a first wiring layer. On the other hand, dot-and-dash lines extending in a direction (for example, Y direction) orthogonal to the extending direction of the center lines $CL_1$ are center lines $CL_2$ which indicate the channel directions of wiring lines 19 formed in a second wiring layer.

Incidentally, Fig. 3B shows only the first wiring layer in Fig. 3A.

Besides, the second wiring layer is formed on the first wiring layer through an inter-layer insulator film not shown, and the wiring lines in the respective layers are connected via through holes 18.

As shown in Fig. 3B, that part of the wiring line 17 at which the through hole (contact hole) 18 for connecting the wiring lines of the different layers is arranged is formed with a dog-bone portion 17a for preventing a misregistration. Also, as regards the wiring lines 17, 17 which adjoin each other, that part of one wiring line 17 which is adjacent to the dog-bone portion 17a of the other wiring line 17 is indented in the direction of coming away from the dog-bone portion 17a, whereby only the width $d_1$ of the indented wiring line portion 17b (the portion which intervenes between the dog-bone portions 17a of the adjacent wiring lines on both sides) becomes smaller than the width $d_2$ of the other wiring line portions 17c of the wiring line 17.

In other words, the wiring line portion 17c of the width $d_2$, which is otherwise fined unnecessarily in conformity with the width $d_1$ of the narrowest wiring line portion 17b, is broader than the wiring line portion 17b of the minimum line width. In this case, however, the width $d_2$ of the wiring line portion 17c is defined so that the spacing $d_4$ between the wiring line portions 17c, 17c adjoining each other may fall within the following range: the spacing $d_3$ between the dog-bone portion 17a and the wiring line portion 17b] $\leq$ [the spacing $d_4$ between the wiring line portions 17c, 17c] < [the spacing $d_5$ between the wiring line portions 17c and 17b]

Thus, in each wiring line 17 of this embodiment, the wiring line portion 17b of the minimum line width is a mere fraction of the whole wiring line 17. Therefore, a rate at which the wiring line portions 17b of the minimum line width appear and a probability at which the wiring line portions 17b of the minimum line width lie over underlying stepped parts become much lower than in the case of the wiring line structure wherein all the parts of the wiring line 17 except the dog-bone portion 17a are set at the minimum line width. Accordingly, the wiring line 17 of this embodiment is structurally adapted to suppress, for example, EM defects as well as SM defects and increase in the resistance of this wiring line.

As shown in Fig. 3A, in this embodiment, the wiring line 19 has the same wiring line structure as that of the wiring line 17. Moreover, the channel pitch D of the wiring lines 19 of the second wiring layer is equalized to the channel pitch D of the wiring lines 17 of the first wiring layer.

The width $d_1$ of the wiring line portion 17b is, for example, about 1.6 - 1.8 $\mu$m. The width $d_2$ of the wiring line portion 17c (as well as the corresponding portion 19c of the wiring line 19) is, for example, about 2.5 - 2.7 $\mu$m. Besides, the spacing $d_3$ between the dog-bone portion 17a (or the dog-bone portion 19a of the wiring line 19) and the wiring line portion 17b (or the portion 19d of the wiring line 19) adjacent thereto is the minimum spacing between the wiring lines 17, 17 (or 19, 19) adjoining each other, and it is about 1.0 - 1.1 $\mu$m by way of example. Incidentally, the wiring lines 17 and 19 are made of, for example, an aluminum (Al) - silicon (Si) - copper (Cu) alloy.

The through holes 18 are the portions for connecting, for example, the first wiring layer and the second wiring layer and are arranged at the points of intersection between the center lines $CL_1$ and the center lines $CL_2$. In each of the through holes 18, its width $d_6$ in the direction orthogonal to the center line $CL_1$ about 1.2 $\mu$m by way of example.

Also, in each of the dog-bone portions 17a, its allowance width $d_7$ for preventing the misregistration is about 0.6 - 0.9 $\mu$m by way of example.

Herein, the through hole 18 may well be enlarged by diminishing the misregistration preventing allow ance width $d_7$.

The distance between the center lines $CL_1$, $CL_1$ extending in parallel with each other indicates the channel pitch D of the wiring lines 17 of the first wiring layer, and it is about 3.0 $\mu$m by way of example. Here, the channel pitch D is determied by, for example, the following formula:
$$D = d_6/2 + d_7 + d_3 + d_1/2$$
As shown in Fig. 3B, the corners 20 of each dog-bone portion 17a are chamfered. That is, the dog-bone portion 17a is substantially in the shape of an octagon into which the corners of a rectangle are chamfered.

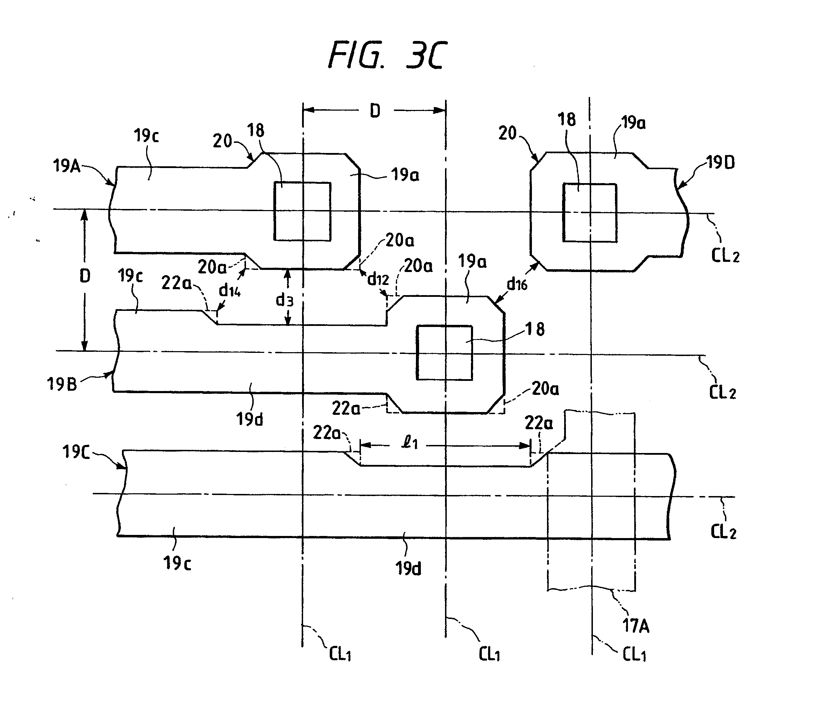

Also, that corner 22 of the wiring line portion 17c which opposes to the chamfered corner 20 obliquely is chamfered. If the corner 20 of the dog-bone portion 17a and the opposing corner 22 of the wiring line portion 17c in the same layer as that of the dog-bone portion 17a are left intact without being chamfered, the spacing between the corners 20 and 22 will become smaller than the minimum spacing $d_3$, and an inferior resolution will be lialbe to occur at the steps of exposure and development. The chamfering operation is performed in order to prevent this drawback. It will be described more concretely with reference to Fig. 3C. The wiring lines 19A, 19B and 19C of the second wiring layer are chiefly illustrated in the figure. In the wiring lines 19A, 19B and 19C and a wiring line 19D, dotted lines 20a indicate the positions of those corners of the dog-bone portions 19a which are assumed to remain without being chamfered. On the other hand, dotted lines 22a indicate the positions of those corners of the wiring line portions 19c which oppose to the corners 20 of the dog-bone portions 19a obliquely and which are assumed to remain without being chamfered. A two-dot chain line indicates the wiring line 17A of the first wiring layer.

When the corners 20a of the dog-bone portions 19a and the opposing corners 22 of the wiring line portions 19c in the same layer as that of the dog-bone portions 19a are left intact without being chamfered, each of the spacing $d_{12}$ between the corners 20a, 20a and the spacing $d_{14}$ between the corner 20a and the corner 22a becomes smaller than the minimum spacing $d_3$. Therefore, the inferior resolution is prone to occur at the exposure and development steps, and the reliability of the wiring lines degrades. On the other hand, when the spacing $d_{12}$ between the corners 20a, 20a is set at a length equal to or greater than the minimum spacing $d_3$, the channel pitch D of the wiring lines 19 of the second wiring layer or the channel pitch D of the wiring lines 17 of the first wiring layer need to be expanded. Therefore, the number of the wiring lines which can be laid decreases, and the efficiency of packaging the logic circuits lowers.

Further, in a case where the spacing $d_{14}$ between the corner 20a and the corner 22a is expanded by increasing the length $\ell_1$ of that part of the wiring line 19C which is adjacent to the dog-bone portion 19a of the wiring line 19B and which is indented in the direction of coming away from the dog-bone portion 19a, the wiring line portion 19d of the small width comes over the wiring line 17A of the first wiring layer, and that part of the wiring line portion 19d which overlies stepped parts ascribable to the first wiring layer enlarges. When the area of the fine wiring line portion 19d over the underlying stepped parts increases, the EM defects as well as the SM defects become liable to occur, and the reliability of the wiring line degrades.

As described above, the corners 20 of the dog-bone portions 17a, 19a are chamfered so that the spacing $d_{16}$ between each corner 20 and the opposing corner 20 of the wiring line adjacent to the dog-bone portion may become greater than the minimum spacing $d_3$. Thus, the inferior resolution can be prevented, and the reliability of the wiring line can be enhanced. Moreover, since the channel pitches D of the first and second wiring layers can be reduced, the number of the wiring lines can be enlarged to raise the efficiency of packaging the logic circuits.

Also, those corners 22 of the wiring line portions 17c, 19c which oppose to the corners 20 of the dog-bone portions 17a, 19a obliquely are chamfered so that the spacing $d_9$ between each corner 20 and the opposing corner 22 may become greater than the minimum spacing $d_3$. Thus, the inferior resolution can be prevented, and the probability at which the wiring line portion of the small width lies over the underlying stepped parts can be lowered to enhance the reliability of the wiring line.

Incidentally, a wiring line structure having rectangular dog-bone portions is disclosed in, for example, the official gazette of Japanese Patent Application Laid-open No. 50448/1982 laid open on March 24, 1982.

An oblique allowance width $d_8$ for preventing the misregistration is, for example, about 0.7 $\mu$m, while the spacing $d_9$ is, for example, about 1.13 $\mu$m. By the way, the oblique allowance width $d_8$ for preventing the misregistration may be equal to or greater than the misregistration preventing allowance width $d_7$, that is $d_8 \geq d_7$ may be held.

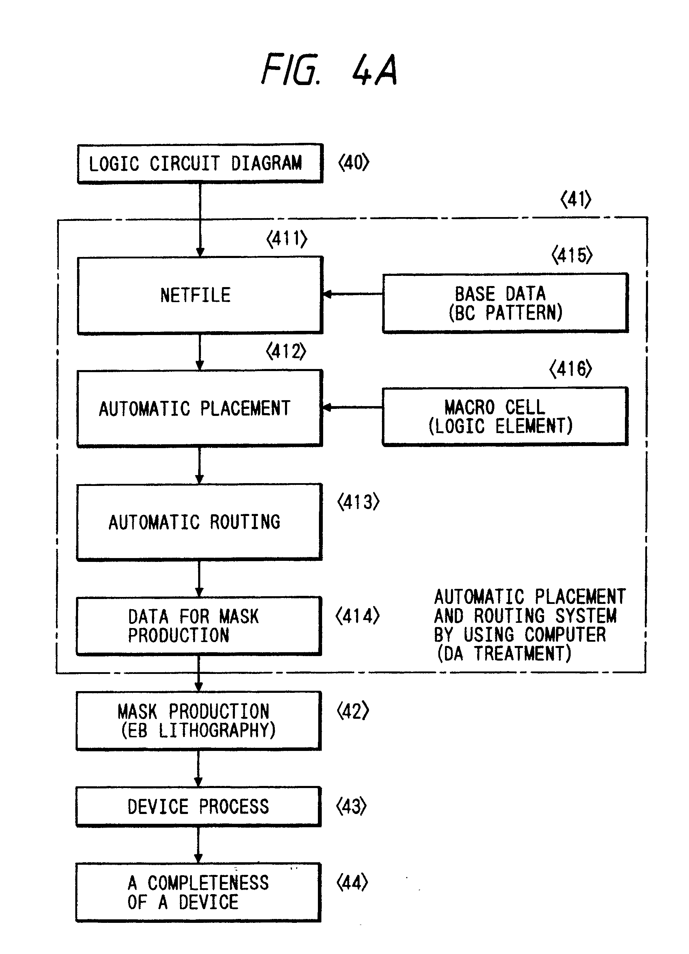

Now, a process for manufacturing the semiconductor integrated circuit device described above will be briefly explained with reference to Figs. 4A - 4B, Figs. 5A - 5C and Figs. 6A - 6D.

As illustrated in Fig. 4A (a process flow chart), logical constructions (functions) to be included in the semiconductor integrated circuit device 10 are first designed to generate a logic circuit diagram <40>.

Subsequently, on the basis of the logic circuit diagram, logic circuits are automatically arranged and connected by an automatic placement and routing system using a computer (DA treatment) <41>. In the automatic placement and routing system, connection information which can be handled in this system is initially input as a net file on the basis of the logic circuit diagram <411>.

Next, on a semiconductor integrated circuit device (base chip) imaginarily expressed as stored in the base data <415> of the automatic placement and routing system, the designed logic circuits are automatically placed <412> on the basis of the connection information having been input to this system. The automatic placement of the logic circuits proceeds in such a way that macrocells (logic elements) <416> stored in the automatic placement and routing system are automatically placed along the basic cell (BC) patterns. <415> denotes the information of the arrayal of the basic cell patterns on the semiconductor integrated circuit device (base chip).

Subsequently, the logic circuits automatically placed are automatically connected on the basis of the connection information, thereby to complete logic circuit information <413>.

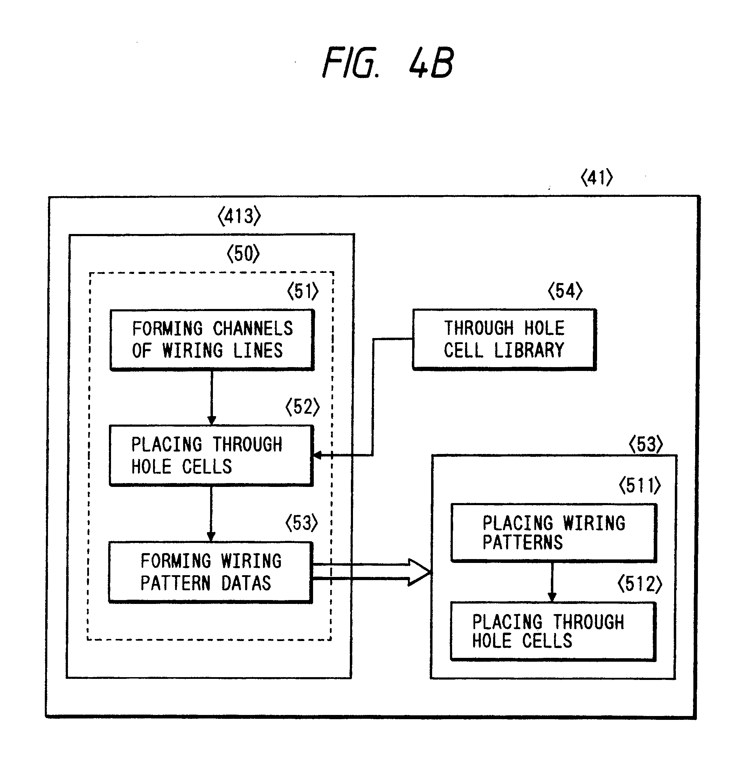

In order to form the wiring line structure stated before, a function <50> shown in Fig. 4B to be described later is supported at the substep <413> of automatically designing the wiring layout.

Next, the logic circuit information completed in the automatic placement and routing system is converted into data for mask production <414> on the basis of design rules within this system. The treatment from the substep <411> of inputting the connection information, to the substep <414> of converting the logic circuit information into the mask producing data is automatically carried out by the automatic placement and routing system.

At the next step <42>, masks for connections are formed by an electron-beam (EB) lithographic apparatus on the basis of the mask producing data.

Subsequently, device processes are performed <43> using the connecting masks. Then, the semiconductor integrated circuit device having the predetermined logical constructions (logic circuits) is substantially completed <44>.

Now, there will be described a case where the wiring pattern data of an actual mask for wiring, for example, is automatically generated from the wiring data which has been generated at the substep of automatically designing the wiring layout.

In order to form the wiring line structure stated before, the function <50> shown in Fig. 4B is supported in the automatic placement and routing system.

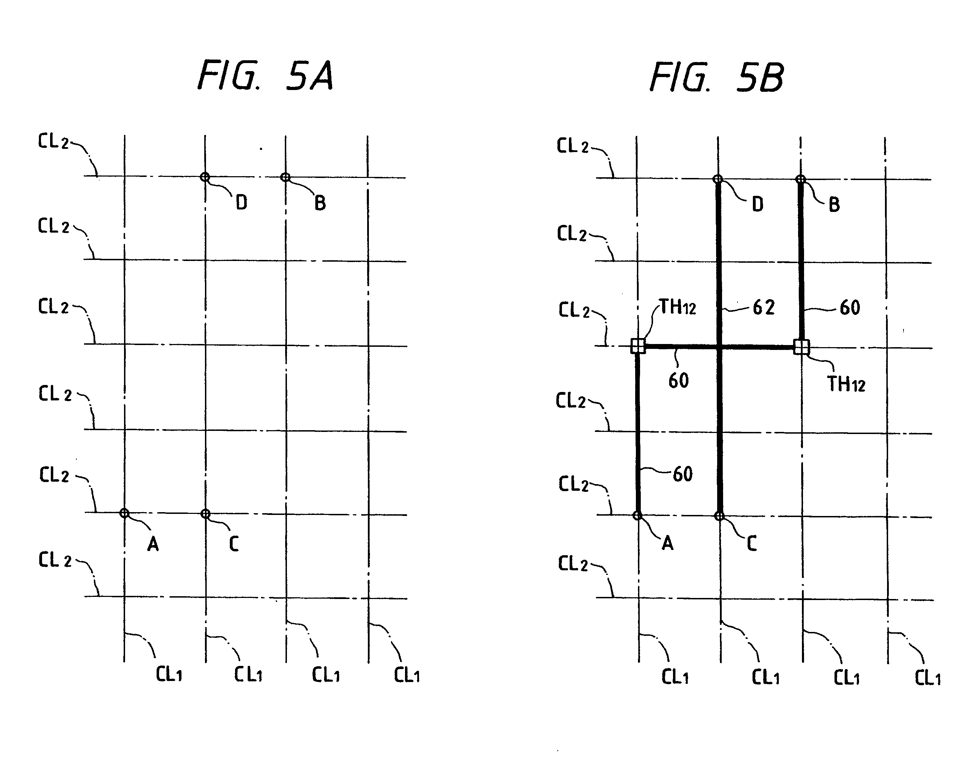

As indicated in Fig. 4B, the channels of wiring lines are first formed automatically on the basis of the connection information <51>. Fig. 5A shows part of a layout plan at the substep of automatically designing the wiring layout after the placement of the macrocells. Letters A - D denote the terminals of the macrocells. At the functional step <51> of forming the wiring line channels, the channels between the terminals A and B and between the terminals C and D are searched for by a channel search method, for example, the maze running method, the line search method or the channel wiring method. Thus, wiring line channels 60 for connecting the terminals A and B, and a wiring line channel 62 for connecting the terminals C and D are automatically generated as shown in Fig. 5B.

At the next functional step <52>, through hole cells (element cells for the contact holes) $TH_{12}$ including information items to be mentioned below are fetched from a through hole cell library <54> and are placed at parts where the first wiring layer and the second wiring layer are to be connected. The through hole cells $TH_{12}$ contain the information for forming the dog-bone portions 17a, 19a, and the information for indenting the parts of the wiring lines adjoining the dog-bone portions 17a, 19a and having different potentials, in the directions of coming away from the dog-bone portions 17a, 19a. Incidentally, the suffixes of the through hole cells TH indicate the wiring layers.

Subsequently, the wiring pattern data is formed <53>. In the automatic placement and routing system, functions <511> and <512> to be explained below are supported for the functional step <53> of forming the wiring pattern data.

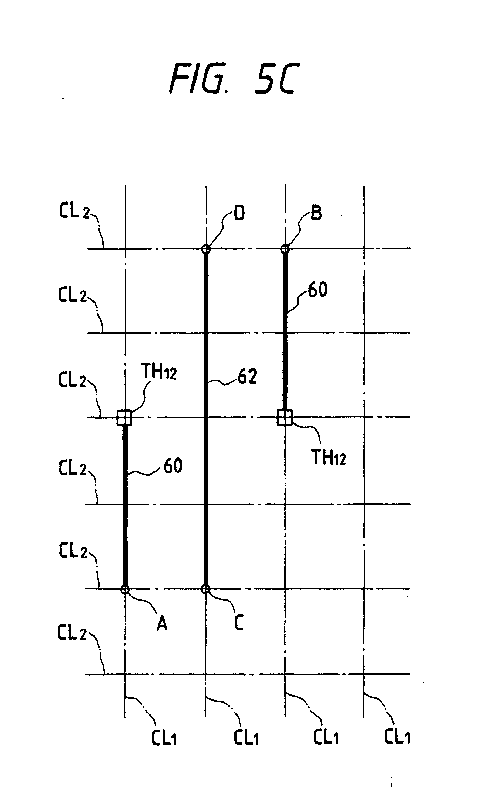

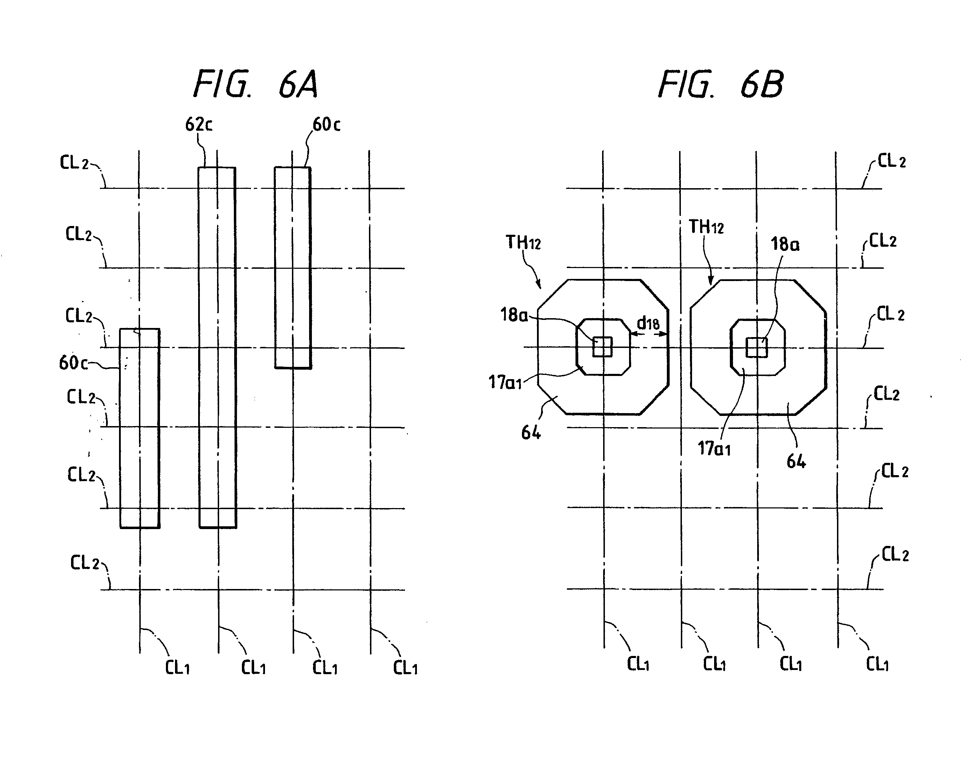

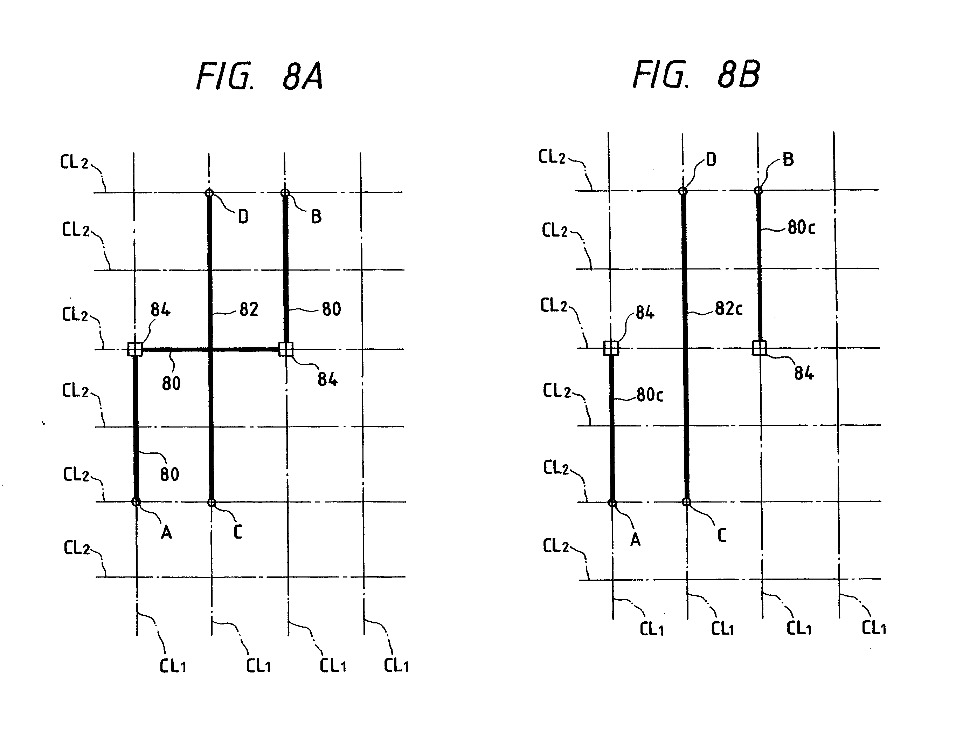

First, as shown in Fig. 5C, the generated wiring line channels 60 and 62 are separated into wiring line data every wiring layer. In Fig. 5C, only the wiring line channels 60 and 62 of the first wiring layer are shown for the brevity of the description. Besides, the wiring line data is automatically converted into pattern data having widths and sizes as illustrated in Figs. 6A and 6B <511>.

Fig. 6A shows only oblong wiring line patterns 60c, 62c generated on the basis of the wiring line data of the wiring line channels 60, 62 (Fig. 5C). The pattern spacing between the wiring line patterns 60c, 62c is equalized to the foregoing minimum spacing $d_3$ between the wiring lines 17, 17 by way of example. Also, the width of each pattern is equalized to the width $d_2$ of the wiring line portion 17c by way of example.

Fig. 6B shows the pattern data of the through hole cells $TH_{12}$. A region 18a which contains information for forming the through hole 18 is set in terms of coordinates at the central part of the pattern data of each through hole cell $TH_{12}$. Around the region 18a, a region $17a_1$ which is in an octagonal shape by way of example and which contains information for forming the dog-bone portion 17a is set in terms of coordinates. Further, around the region $17a_1$, a region 64 which contains information for indenting the part of the wiring line adjacent to the dog-bone portion 17a and at the different potential in the direction of coming away from this dog-bone portion 17a is set in terms of coordinates. The region 64 is so defined that, when the wiring line of the different potential not connected with the dog-bone portion 17a has overlapped this region 64, the overlapping part of the wiring line is cut off. The width $d_8$ of the region 64 is equalized to the minimum spacing $d_3$ by way of example.

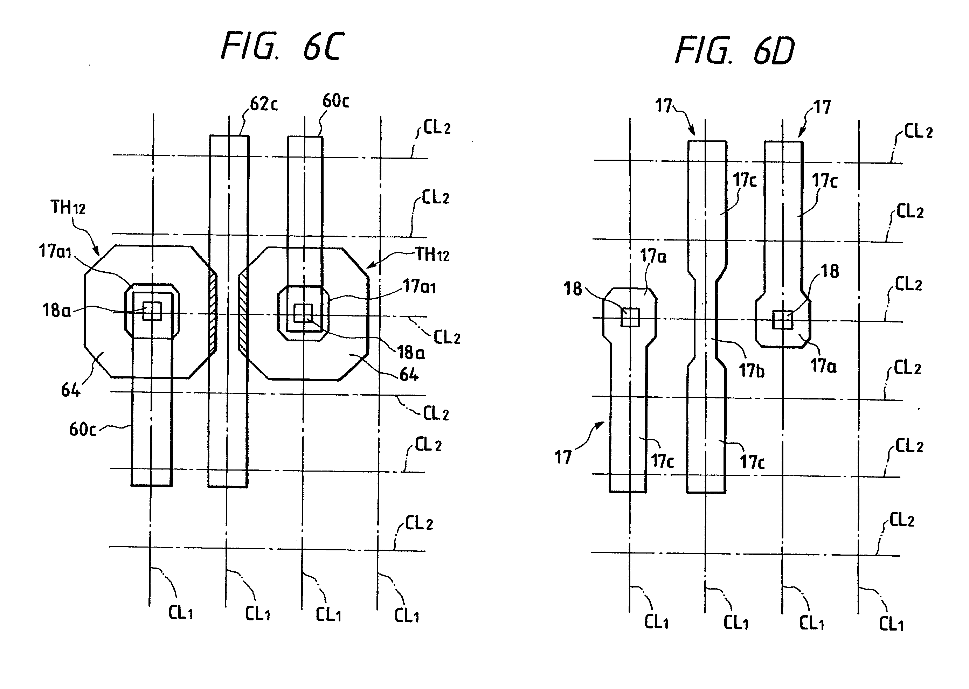

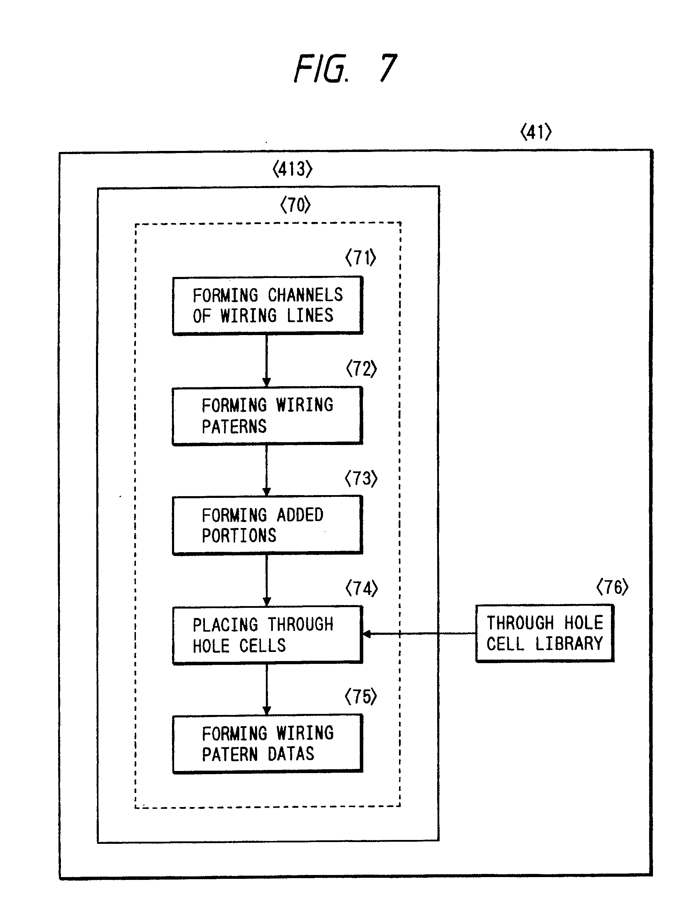

Subsequently, the items of pattern data in Figs. 6A and 6B are combined as shown in Fig. 6C <512>. Then, the part of the wiring line pattern 62c adjacent to the region $17a_1$ is cut off so that the spacing between the region $17a_1$ and the wiring

line pattern 62c may become the minimum spacing $d_3$. However, the definition of the region 64 is applied, neither to the wiring line pattern 60 of the same potential to be connected with the region $17a_1$, nor to the region $17a_1$ connected to the adjacent wiring line pattern. Incidentally, hatches in Fig. 6C indicate those parts of the wiring line pattern 62c which the regions 64 overlap and which are to be cut off.

In this way, as shown in Fig. 6D, there is generated the wiring pattern data according to which, in the wiring lines 17, 17 adjoining each other, the part of the wiring line 17 adjacent to the dog-bone portion 17a is formed with the indent in the direction of coming away from the dog-bone portion 17a, so that only the wiring line portion 17b intervening between the dog-bone portions 17a becomes the minimum line width.

Thereafter, the wiring pattern data is converted into the mask producing data on the basis of the design rules in the automatic placement and routing system <414>.

By the way, the wiring pattern data generated as described above is also usable as, for example, wiring pattern data for an apparatus for the direct lithography of a wafer.

In this manner, in a process for forming a semiconductor integrated circuit device adopting a gate array scheme by the use of an automatic placement and routing system, this embodiment comprises the functional step <511> of placing wiring patterns 60c, 62c on the basis of connection information, and the functional step <512> of placing through hole cells $TH_{12}$ the positions of contact holes, the cells $TH_{12}$ containing information for indenting those parts of the wiring pattern 62c which are adjacent to dog-bone portions $17a_1$.

According to this embodiment, the following effects can be attained:

(a) In a semiconductor integrated circuit device with multilayer wiring wherein wiring layers and at least one inter-layer insulator film are alternately stacked, wiring lines include dog-bone portions 17a, 19a around contact holes 18 for connecting the different wiring layers, and each of the dog-bone portions 17a, 19a has its corners 20 chamfered (into an octagonal shape). Therefore, an inferior resolution can be prevented to enhance the reliability of the wiring lines. Simultaneously, channel pitches D in an X direction ($CL_1$-direction) and in a Y direction ($CL_2$-direction) can be reduced to raise the efficiency of packaging logic circuits.

(b) In the above item (a), those parts of the wiring lines 17, 19 adjoining each other which are adjacent to the dog-bone portions 17a, 19a are indented in the directions of coming away from the dog-bone portions 17a, 19a, whereby only the width $d_1$ of a wiring line portion 17b which intervenes between the dog-bone portions of the adjoining wiring lines is set at the minimum line width, while each of the widths $d_2$, $d_{10}$ of the other wiring line portions 17c, 19d is made greater than the minimum line width. Thus, the part of the minimum line width (the wiring line portion 17b) becomes a mere fraction of the whole wiring line 17. Therefore, a rate at which the wiring line portions 17b of the minimum line width appear and a probability at which the wiring line portions 17b of the minimum line width lie over underlying stepped parts can be sharply lowered as compared with those of a wiring line structure wherein the entire part of the wiring line 17 except the dog-bone portion 17a is set at the minimum line width.

Moreover, that portion 19c of the wiring line 19 which is in the same layer as that of the dog-bone portion 19a having the corners 20 has its corners 22 opposite to the corners 20 chamfered. Therefore, the inferior resolution can be prevented, and the probability at which the wiring line portions 19d of the small width $d_{10}$ lie over the underlying stepped parts ascribable to the lower-layer wiring lines 17A can be diminished.

(c) Owing to the above item (b), the current density of the wiring line 17 can be lowered. Therefore, it becomes possible to enhance the EM immunity of the wiring line 17.

In addition, the broad regions of the wiring lines 17, 19 increase, and bamboo grain boundaries become difficult to be formed in the wiring lines 17, 19. Therefore, it becomes possible to enhance the SM immunities of the wiring lines 17, 19. Moreover, it becomes possible to lower the resistances of the wiring lines.

(d) Owing to the above items (a) - (c), it becomes possible to sharply enhance the reliabilities of the wiring lines 17, 19 and to obtain a semiconductor integrated circuit device 10 of high reliability.

(e) At the substep <412> of automatically designing a wiring layout, through hole cells $TH_{12}$ are placed in each of which the portion of the through hole 18 for connecting the wiring lines of the different layers is furnished with information for indenting the part of the wiring line adjacent to the dog-bone portion 17a <12>. This makes it possible to generate wiring pattern data according to which only the width $d_1$ of the wiring line portion 17b adjacent to the dog-bone portion 17a becomes the minimum line width. Therefore, a short time suffices for the generation of the wiring pattern data.

Moreover, owing to the generation of the wiring pattern data according to which only the width $d_1$ of the wiring line portion 17b adjacent to the dog-bone portion 17a becomes the minimum line width, the reliabilities of the wiring lines 17, 19 and the efficiency of packaging the logic circuits can be enhanced without spoiling the easiness of the wiring layout.

Embodiment 2:

This embodiment 2 is the second embodiment of the present invention which differs from the foregoing embodiment 1 in the process for forming a semiconductor integrated circuit device.

In the process of this embodiment for forming the semiconductor integrated circuit device, a function <70> shown in Fig. 7 is supported instead of the function <50> which is supported at the substep of the automatic wiring layout design <413> in Embodiment 1.

As illustrated in Fig. 7, the channels of wiring lines are first generated automatically on the basis of connection information in the same manner as in Embodiment 1 <71>. At the functional step <71> of generating the channels of the wiring lines, the wiring line channels 80, 82 as shown in Fig. 8A are generated, and they are thereafter separated every wiring layer as shown in Fig. 8B, thereby to hold the separated channels as layout information. Fig. 8B shows only the wiring line channels 80c, 82c of the first wiring layer for the brevity of the description.

Here, the wiring line channels 80c, 82c, etc. of the respective wiring layers contain wiring line width information, and placement position information for placing through hole cells at parts 84 where the first wiring layer and the second wiring layer are to be connected.

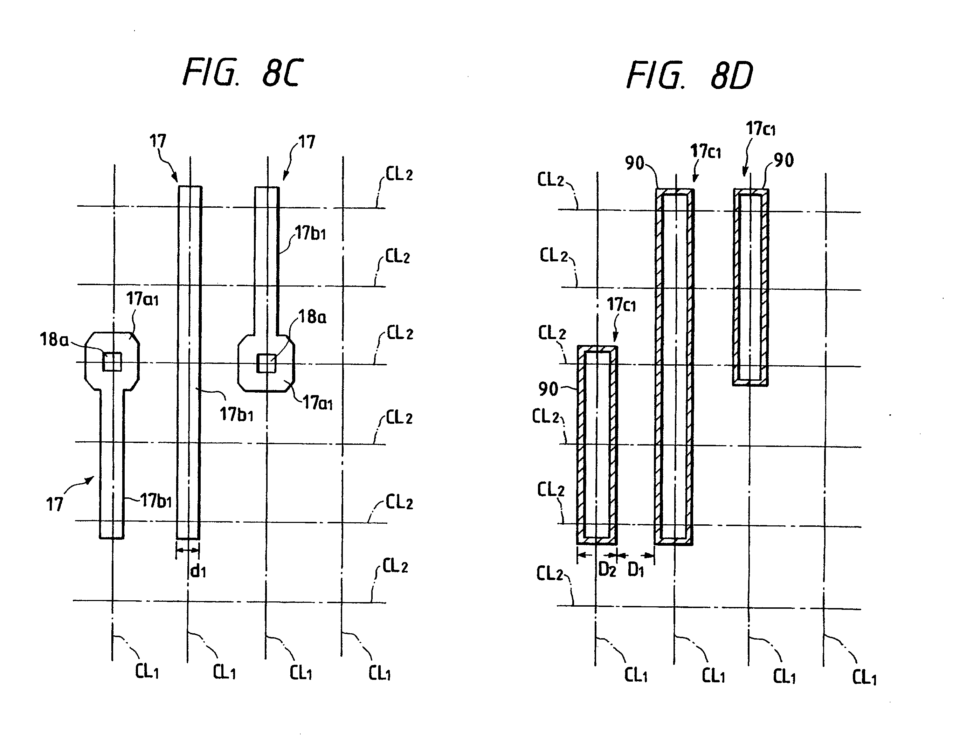

At the next functional step <72>, on the basis of the layout information, the wiring line channels 80c, 82c, etc. of the respective wiring layers are automatically converted into pattern data (wiring patterns) having widths and sizes as shown in Fig. 8C. This figure shows the oblong wiring patterns $17b_1$ and octagonal regions $17a_1$ containing coordinate information for forming dog-bone portions 17a, these patterns $17b_1$ and regions $17a_1$ having been generated on the basis of the layout information of the wiring line channels 80c, 82c. By way of example, the wiring line width of each of the wiring patterns $17b_1$ is equalized to the width $d_1$ of the wiring line portion 17b of the minimum line width stated before. The pattern data is held as wiring pattern data A.

At the subsequent functional step <73>, on the basis of the layout information, the wiring line channels 80c, 82c, etc. of the respective wiring layers are automatically converted into pattern data (wiring patterns $17c_1$, etc.) having widths and sizes as shown in Fig. 8D. This figure shows the oblong wiring patterns $17c_1$ which have been generated on the basis of the layout information of the wiring line channels 80c, 82c.

Each of the wiring patterns $17c_1$ includes an oblong bulge portion 90 which is illustrated as a hatched region surrounding the oblong wiring pattern $17b_1$. The bulge portion 90 contains information for adding this bulge portion 90 to the wiring pattern $17b_1$, and coordinate information for indenting the wiring pattern $17b_1$ in the direction of coming away from the dog-bone portion $17a$.

The pattern spacing $D_1$ between the wiring patterns $17c_1$ is equalized to the foregoing minimum spacing $d_3$ between the wiring lines 17, 17 by way of example. Besides, the pattern width $D_2$ of each wiring pattern $17c_1$ is equalized to the foregoing width $d_2$ of the wiring line portion $17c$ by way of example.

Such pattern data is held as wiring pattern data B.

At the subsequent functional step <74>, the through hole cells (element cells for contact holes) $TH_{12}'$ containing information to be stated below are fetched from a through hole cell library <76>, and they are placed at the through hole cell placing positions of the wiring patterns $17c_1$ as shown in Fig. 8E.

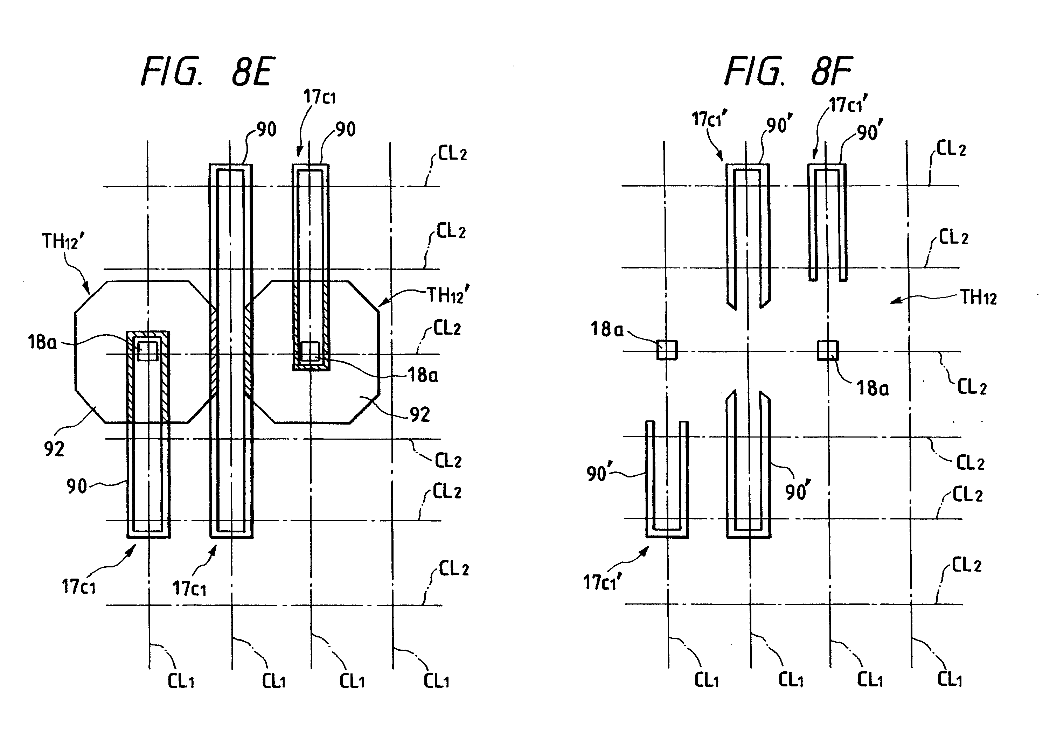

A region $18a$ which contains the information for forming the through hole 18 is set in terms of coordinates at the central part of the pattern data of each of the through hole cells $TH_{12}'$. Around the region $18a$, a region 92 which contains the information for indenting the part of the wiring line adjacent to the dog-bone portion $17a$ in the direction of coming away from this dog-bone portion $17a$ is set in terms of coordinates. The region 92 is so defined that, when it overlaps the bulge portion 90, the overlapping wiring line part is cut off. In Fig. 8E, hatched regions indicate the wiring line parts where the regions 92 and the bulge portions 90 overlap and where the bulge portions 90 are to be cut off. Thus, wiring patterns $17c_1'$ having bulge portions $90'$ in shapes shown in Fig. 8F are held as wiring pattern data C.

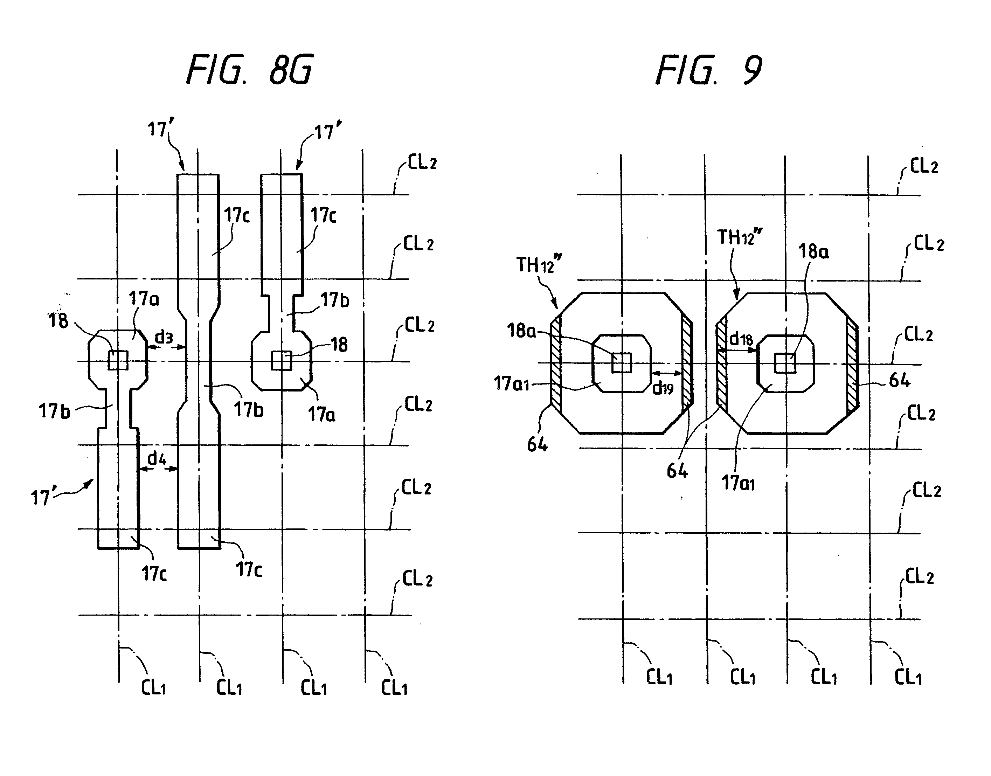

Subsequently, as shown in Fig. 8G, the pattern data in Fig. 8C and the pattern data in Fig. 8F are combined to generate wiring pattern data $17'$ <75>. Thus, there is generated the wiring pattern data according to which, in the wiring lines 17, 17 adjoining each other, the part of the wiring line adjacent to the dog-bone portion $17a$ is formed with the indent in the direction of coming away from this dog-bone portion $17a$, and the wiring line portion $17b$ intervening between the dog-bone portions $17a$ becomes the minimum line width.

Thereafter, the wiring pattern data is converted into data for mask production on the basis of design rules in the automatic placement and routing system as in Embodiment 1 <414>.

In this manner, in a process for forming a semiconductor integrated circuit device adopting a gate array scheme by the use of an automatic placement and routing system, this embodiment comprises the functional step <72> of generating first wiring patterns $17b_1$, $17a_1$ on the basis of connection information, the functional step <73> of generating wiring patterns $17c_1$ which contain information for adding bulge portions 90 to the wiring patterns $17b_1$, the functional step <74> of generating wiring patterns $17c_1'$ in such a way that through hole cells $TH_{12}'$ which contain information for cutting off the parts of the wiring patterns $17c_1$ adjacent to the dog-bone portions $17a_1$ are placed in the wiring patterns $17c_1$, and the functional step <75> of combining the wiring patterns $17c_1'$ with the wiring patterns $17b_1$, $17a_1$, thereby to generate wiring pattern data $17'$.

The semiconductor integrated circuit device thus formed can achieve the following effect besides the effects of Embodiment 1:

At the functional step of placing the through hole cells $TH_{12}'$ <74> within the substep of automatically designing the wiring layout <413>, it is dispensed with to execute the processing in Embodiment 1 that the definition of the region 11 is not applied to the wiring pattern 60 which is equal in potential to the dog-bone portion $17a_1$. Therefore, a period of time for generating the wiring pattern data can be shortened to that extent.

Embodiment 3:

This embodiment 3 is the third embodiment of the present invention which differs from the foregoing embodiment 1 in the pattern data of through hole cells.

Fig. 9 shows the pattern data of the through hole cells $TH_{12}''$ in this embodiment. Unlike Embodiment 1, this embodiment is provided with regions 64, indicated by hatched regions, at parts of the through hole cells $TH_{12}''$. A distance $d_{18}$ is equal to, for example, the minimum spacing $d_3$ mentioned before, while a distance $d_{19}$ is equal to, for example, $d_3 - (d_2 - d_1)/2$ where $d_2$ and $d_1$ denote the widths mentioned before. Thus, the wiring pattern data shown in Fig. 6D is generated as in Embodiment 1.

The semiconductor integrated circuit device formed in this way can achieve effects similar to those of the foregoing embodiment 2.

Although, in the above, the invention made by the inventor has been concretely described in conjunction with embodiments, it is a matter of course that the present invention is not restricted to the foregoing embodiments, but that it can be variously altered within a scope not departing from the purport thereof.

By way of example, the embodiments have referred to the case where the logic circuit blocks and the input/output circuit blocks are constructed of the Bi-CMOS circuits. However, this construction is not restrictive but is variously alterable, and ECL circuits or CMOS circuits, for example, may well be employed.

Besides, each of the embodiments has been described as to the case where all the circuit blocks of the semiconductor integrated circuit device is constructed using the wiring lines of the structure explained in the embodiment. However, the wiring structure is not restrictive, but especially wiring lines to be formed over regions of severe stepped parts, for example, may well be brought into the structure explained in the embodiment.

In the foregoing, the invention made by the inventor has been chiefly described as to the case of the applications to that hybrid gate array with the memory which is the field of utilization forming the background of the invention. However, the present invention is not restricted to the hybrid gate array, but it is also applicable to other various semiconductor integrated circuit devices, for example, gate arrays, standard cells, and general-purpose LSIs.

Effects which are attained by typical aspects of performance of the present invention are briefly explained as follows:

In a semiconductor integrated circuit device wherein a dog-bone portion is formed around a contact hole which connects wiring lines of different layers and which is provided in at least either of wiring lines laid in an identical wiring layer and adjoining each other, the dog-bone portion has its corners chamfered substantially into an octagonal shape. In addition, that portion of one of the wiring lines adjoining each other which is adjacent to the dog-bone portion is indented in the direction of coming away from this dog-bone portion, whereby only the width of the wiring line portion is made smaller than that of any other portion of the pertinent wiring line. Besides, the corners of the indented wiring line portion are similarly chamfered.

According to these measures, a rate at which fine wiring lines appear and a probability at which the fine wiring lines lie over underlying stepped parts can be sharply lowered as compared with those of the prior art. Therefore, the EM immunity and SM immunity, for example, of the wiring lines can be enhanced, and the resistances of the wiring lines can be lowered, so that the reliability of the wiring can be enhanced. Moreover, wiring pitches (channel pitches) can be reduced in both X and Y directions, so that the efficiency of packaging logic circuits can be raised by increasing the number of wiring lines.

Meanwhile, in manufacturing the semiconductor integrated circuit device described above, through hole cells (element cells for contact holes) which contain information for indenting only the wiring line portions adjacent to the dog-bone portions in the directions of coming away from these dog-bone portions are placed at the positions of the contact holes at the step of automatically designing a wiring layout.

According to this process for manufacturing the semiconductor integrated circuit device, wiring patterns can be designed so that, by way of example, only the wiring line portions adjacent to the dog-bone portions may become the minimum line width. Therefore, the reliability of the wiring can be enhanced without spoiling the easiness of the wiring layout. Moreover, the efficiency of packaging the logic circuits can be enhanced without spoiling the easiness of the wiring layout.

## Claims

1. A semiconductor integrated circuit device having multiple wiring layers over a semiconductor substrate, comprising:
wiring lines (17, 19) having dog-bone portions (17a, 19a) around contact holes (18) for connecting the different wiring layers;
wherein each of said dog-bone portions (17a, 19a) is in a shape in which its corners (20) are chamfered.

2. A semiconductor integrated circuit device according to claim 1, wherein a wiring line portion (17b or 19b) which is adjacent to said dog-bone portion (17a or 19a) and which is provided in, at least, either of the wiring lines formed in the identical wiring layer and adjoining each other is indented in a direction of coming away from said dog-bone portion, thereby to make a width of said wiring line portion (17b or 19b) smaller than that of a portion (17c or 19c) not indented.

3. A semiconductor integrated circuit device according to claim 2, wherein corners (22) of each of the indented wiring line portions (17b, 19b) are chamfered.

4. A semiconductor integrated circuit device according to any of claims 1 thru 3, wherein said each dog-bone portion (17a or 19a) is in the shape in which the corners (20) of a rectangular shape are chamfered.

5. A semiconductor integrated circuit device according to any of claims 1 thru 4, wherein said each dog-bone portion (17a or 19a) is substantially in an octagonal shape.

6. A semiconductor integrated circuit device according to any of claims 1 thru 5, wherein said multiple wiring layers include wiring layers (17, 19) which extend orthogonally to each other with an inter-layer insulator film interposed therebetween.

7. A semiconductor integrated circuit device according to any of claims 1 thru 6, wherein said wiring lines are signal wiring lines of the semiconductor integrated circuit device adopting a gate array scheme.

8. A process for forming semiconductor integrated circuit device adopting a gate array scheme, by the use of an automatic placement and routing system, comprising:
the step <511> of placing wiring patterns (60c, 62c) on the basis of connection information; and
the step <512> of placing through hole cells ($TH_{12}$) each of which contains information for indenting a part of said wiring pattern (62c) adjacent to a dog-bone portion ($17a_1$).

9. A process for forming a semiconductor integrated circuit device adopting a gate array scheme, by the use of an automatic placement and routing system, as defined in claim 8, wherein said each through hole cell ($TH_{12}$) is substantially in an octagonal shape.

10. A process for forming a semiconductor integrated circuit device adopting a gate array scheme, by the use of an automatic placement and routing system, as defined in either of claims 8 and 9, wherein siad dog-bone portion ($17a_1$) is substantially in an octagonal shape.

11. A process for forming a semiconductor integrated circuit device adopting a gate array scheme, by the use of an automatic placement and routing system, as defined in any of claims 8 thru 10, wherein the indenting information of said through hole cell ($TH_{12}$) is not applied to the dog-bone portion ($17a_1$) which is connected to the adjacent wiring pattern.

12. A process for forming a semiconductor integrated circuit device adopting a gate array scheme, by the use of an automatic placement and routing system, as defined in any of claims 8 thru 11, wherein said through hole cell ($TH_{12}$) further contains information for forming said dog-bone portion ($17a_1$).

13. A process for forming a semiconductor integrated circuit device adopting a gate array scheme, by the use of an automatic placement and routing system, comprising:
the step <72> of generating first wiring patterns ($17b_1$, $17a_1$) on the basis of connection information;
the step <73> of generating second wiring patterns ($17c_1$) each of which contains information for adding a bulge portion (90) to said first wiring pattern ($17b_1$);
the step <74> of generating third wiring patterns ($17c_1'$) in such a way that through hole cells ($TH_{12}'$), each of which contains information for cutting off a part of said second wiring pattern ($17c_1$) adjacent to the dog-bone portion ($17a_1$), are placed in said second wiring patterns ($17c_1$); and
the step <75> of generating wiring pattern data

($17'$) in such a way that said third wiring patterns ($17c_1'$) are combined with said first wiring patterns ($17b_1$, $17a_1$).

14. A process for forming a semiconductor integrated circuit device adopting a gate array scheme, by the use of an automatic placement and routing system, as defined in claim 13, wherein said each through hole cell ($TH_{12}'$) is substantially in an octagonal shape.

15. A process for forming a semiconductor integrated circuit device adopting a gate array scheme, by the use of an automatic placement and routing system, as defined in either of claims 13 and 14, wherein said dog-bone portion ($17a_1$) is substantially in an octagonal shape.

# FIG. 1

# FIG. 2

FIG. 3A

EP 0 414 412 A2

## FIG. 3B

# FIG. 3C

EP 0 414 412 A2

# FIG. 4A

```
┌─────────────────────────────┐
│   LOGIC CIRCUIT DIAGRAM      │  ⟨40⟩
└─────────────────────────────┘
                │                                              ⟨41⟩
┌───────────────┼──────────────────────────────────────────────────┐
│               ▼                    ⟨411⟩                    ⟨415⟩  │
│      ┌─────────────────┐              ┌─────────────────────────┐  │
│      │     NETFILE      │◄─────────── │   BASE DATA             │  │
│      └─────────────────┘              │   (BC PATTERN)          │  │
│               │            ⟨412⟩       └─────────────────────────┘  │
│               ▼                                            ⟨416⟩   │
│      ┌─────────────────┐              ┌─────────────────────────┐  │
│      │AUTOMATIC PLACEMENT│◄────────── │   MACRO CELL            │  │
│      └─────────────────┘              │   (LOGIC ELEMENT)       │  │
│               │                        └─────────────────────────┘  │
│               ▼            ⟨413⟩                                    │
│      ┌─────────────────┐                                           │
│      │ AUTOMATIC ROUTING│                                          │
│      └─────────────────┘                                           │
│               │                        AUTOMATIC PLACEMENT         │
│               ▼            ⟨414⟩        AND ROUTING SYSTEM          │
│      ┌─────────────────┐               BY USING COMPUTER           │
│      │  DATA FOR MASK   │               (DA TREATMENT)             │
│      │  PRODUCTION      │                                          │
│      └─────────────────┘                                           │
└───────────────┼──────────────────────────────────────────────────┘
                ▼
      ┌─────────────────┐
      │ MASK PRODUCTION  │  ⟨42⟩
      │ (EB LITHOGRAPHY) │
      └─────────────────┘
                │
                ▼
      ┌─────────────────┐
      │  DEVICE PROCESS  │  ⟨43⟩
      └─────────────────┘
                │
                ▼
      ┌─────────────────┐
      │ A COMPLETENESS   │  ⟨44⟩
      │ OF A DEVICE      │
      └─────────────────┘
```

# FIG. 4B

⟨41⟩

⟨413⟩

⟨50⟩

⟨51⟩

FORMING CHANNELS
OF WIRING LINES

⟨54⟩

THROUGH HOLE
CELL LIBRARY

⟨52⟩

PLACING THROUGH
HOLE CELLS

⟨53⟩

⟨53⟩

FORMING WIRING
PATTERN DATAS

⟨511⟩

PLACING WIRING
PATTERNS

⟨512⟩

PLACING THROUGH
HOLE CELLS

FIG. 5B

FIG. 5A

## FIG. 5C

FIG. 6B

FIG. 6A

# FIG. 6C

62c    60c

CL₂

CL₂

TH₁₂

17a₁

TH₁₂

18a

17a₁

CL₂

18a

64

64

60c

CL₂

CL₂

CL₂

CL₁    CL₁    CL₁    CL₁

# FIG. 6D

17         17

CL₂

17c    17c

CL₂

17a

18         18

CL₂

17b    17a

CL₂

17

17c    17c

CL₂

CL₂

CL₁    CL₁    CL₁    CL₁

EP 0 414 412 A2

EP 0 414 412 A2

# FIG. 7

⟨41⟩

⟨413⟩

⟨70⟩

⟨71⟩
FORMING CHANNELS
OF WIRING LINES

⟨72⟩
FORMING WIRING
PATERNS

⟨73⟩
FORMING ADDED
PORTIONS

⟨74⟩
PLACING THROUGH
HOLE CELLS

⟨76⟩
THROUGH HOLE
CELL LIBRARY

⟨75⟩
FORMING WIRING
PATERN DATAS

23

FIG. 8B

FIG. 8A

# FIG. 8C

# FIG. 8D

EP 0 414 412 A2

FIG. 8E

FIG. 8F

TH₁₂′

18a

92

90

17c₁

17c₁

17c₁

90

90

18a

92

CL₂

CL₂

TH₁₂′

CL₂

CL₂

CL₂

CL₁

CL₁

CL₁

CL₁

17c₁′

90′

17c₁′

90′

18a

TH₁₂

18a

90′

90′

17c₁′

CL₂

CL₂

CL₂

CL₂

CL₂

CL₁

CL₁

CL₁

CL₁

EP 0 414 412 A2

26

FIG. 8G

FIG. 9

EP 0 414 412 A2